# EUROPEAN PATENT APPLICATION

(11) **EP 4 550 595 A1**
(43) Date of publication of application: **07.05.2025**
(21) Application number: 24207859.0
(22) Date of filing: 21.10.2024
(51) Int. Cl.: H02B 1/46, H01R 13/46, H05K 5/02, B60R 16/023

(54) **HIGH-VOLTAGE POWER DISTRIBUTION UNIT**

(30) Priority: 31.10.2023 CN 202311425630
(71) Applicant: Suzhou Littelfuse Ovs Ltd., Suzhou, Jiangsu 215021 (CN)
(72) Inventor: Li, Vector, Suzhou, 215021 (CN); Liu, Renan, Suzhou, 215021 (CN); Pan, Shangchun, Suzhou, 215021 (CN)
(74) Representative: Arnold & Siedsma

(57) **Abstract**

A high-voltage power distribution (100) unit includes a housing (114), a cover (112), and a protection plate (102, 104). The housing (114) holds an electrical device and has a top opening to receive the cover (112). Once the cover (112) is disposed over the housing (114), the housing (114) and the cover (112) form a closed structure. The protection plate (102, 104) is located on one side of the housing (114) and has a receptacle (116, 118) through which an output female connector (106, 108) fits.

## Description

### BACKGROUND

A high-voltage power distribution unit (HV PDU) is an electrical box containing high-voltage DC contactors and fuses. The HV PDU may be enclosed in an IP67/6K9K-rated enclosure and may optimize power distribution using busbars and printed circuit board assemblies. The HV PDU may also feature temperature- and current-sensing capabilities to safely, reliably, and efficiently distribute power from a high-voltage battery module to the high-voltage systems of an environment, such as one supporting hybrid electric vehicles (HEVs).

HV PDUs typically feature a housing and cover or lid for safely holding the components. During maintenance, power to the PDU is disabled and the lid is removed. Some PDUs feature lid switches that are designed to automatically disable power to the PDU as the lid is removed. If the lid switch is poorly designed or corroded, the components of the PDU may be powered despite the fact that the lid is opened, which may result in electric shock, fire, or worse.

It is with respect to these and other considerations that present improvements may be useful.

### BRIEF SUMMARY

This summary is provided to introduce a selection of concepts in a simplified form that are further described below in the detailed description. This summary is not intended to identify key feature or essential features of the claimed subject matter, nor is it intended as an aid in determining the scope of the claimed subject matter.

An exemplary embodiment of a high-voltage power distribution unit in accordance with the present disclosure may include a housing, a cover, and a protection plate. The housing holds an electrical device and has a top opening to receive the cover. Once the cover is disposed over the housing, the housing and the cover form a closed structure. The protection plate is located on one side of the housing and has a receptacle through which an output female connector fits.

An exemplary embodiment of a power distribution unit in accordance with the present disclosure may include a housing with a cover and a protection plate. The cover is placed over a top opening of the housing to form a rectangular cube structure housing an electrical device. The protection plate has an output receptacle through for receiving an input female connector. The protection plate is connected to the cover. The cover is not removable from the housing until the input female connector is removed from the housing.

### BRIEF DESCRIPTION OF THE DRAWINGS

**FIGs. 1A-1C** are diagrams illustrating a high-voltage power distribution unit, in accordance with exemplary embodiments;
**FIGs. 2A-2B** are diagrams illustrating the protection plates used in the high-voltage power distribution unit of **FIGs. 1A-1C**, in accordance with exemplary embodiments;
**FIGs. 3A-3B** are diagrams illustrating the lid switch design of a prior art high-voltage power distribution unit, in accordance with the prior art;
**FIGs. 4A-4F** are diagrams illustrating a U slot design used in the high-voltage power distribution unit of **FIGs. 1A-1C****,** in accordance with exemplary embodiments;
**FIGs. 5A-5E** are diagrams illustrating a hook design used in the high-voltage power distribution unit of **FIGs. 1A-1C****,** in accordance with exemplary embodiments;
**FIGs. 6A-6E** are diagrams illustrating a bump ball design used in the high-voltage power distribution unit of **FIGs. 1A-1C****,** in accordance with exemplary embodiments; and
**FIGs. 7A-7D** are diagrams illustrating steps for opening the cover of the high-voltage power distribution unit of **FIGs. 1A-1C****,** in accordance with exemplary embodiments;

### DETAILED DESCRIPTION

A high-voltage power distribution unit (HV PDU) provides mechanical means to ensure that no power is issued to the PDU once the cover is removed. The HV PDU features a pair of protection plates disposed on either side of the PDU housing. The protection plates move in concert with the cover as the cover is removed from the housing. The HV PDU includes a U-slot design, a hook feature, and a bump ball feature to ensure high reliability and safety. The HV PDU needs not rely on poka-yoke processes or end of line process testing after assembly.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

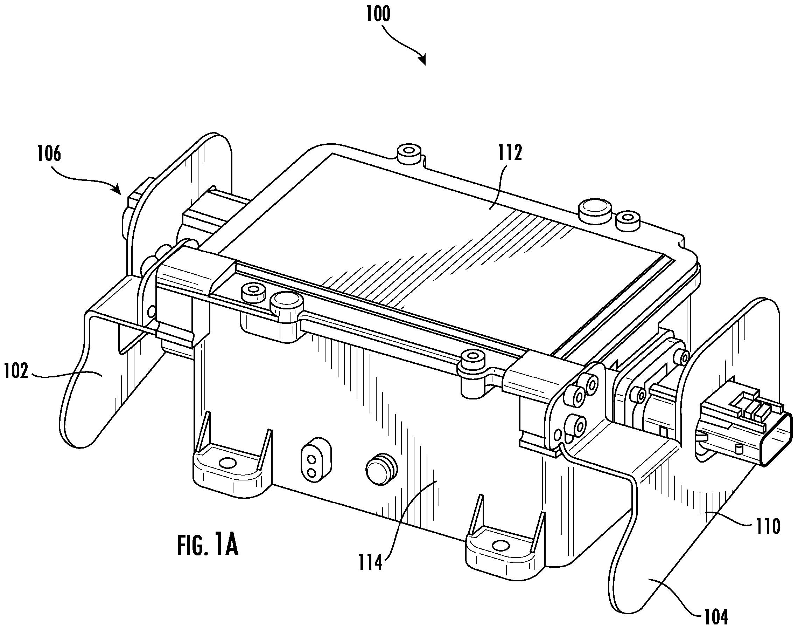

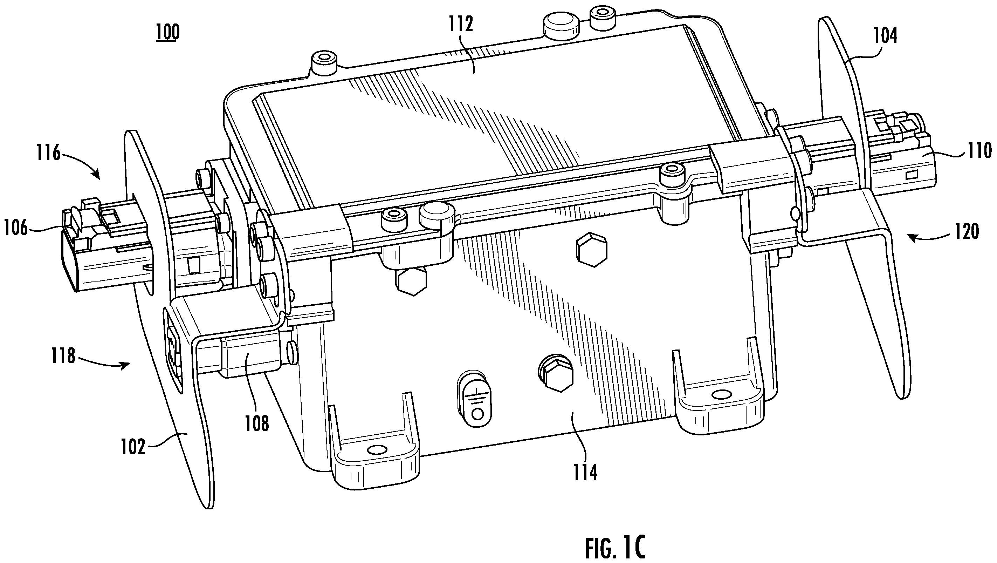

**FIGs. 1A-1C** are representative perspective views of a novel high-voltage power distribution unit (HV PDU) 100, according to exemplary embodiments. The HV PDU 100 consists of a housing 114, which is open at the top, and a cover 112 to be disposed over the opening of the housing 114 for enclosing components therein. In exemplary embodiments, the housing 114 and the cover 112 together form a closed structure that is a rectangular cube structure.

The HV PDU 100 supports three female connectors: an output female connector 106, a low voltage female connector 108, and an input female connector 110. In exemplary embodiments, the output female connector 106 and the low voltage female connector 108 are disposed on a first side of the housing 114 while the input female connector 110 is disposed on a second, opposite side of the housing. In exemplary embodiments, the output female connector 106, the low voltage female connector 108, and the input female connector 110 are plugged into the housing such that the connectors establish electrical connections to components within the housing 114 of the HV PDU 100.

In exemplary embodiments, the HV PDU 100 features a first protection plate 102, disposed on the first side of the housing 114, and a second protection plate 104, disposed on the second side of the housing. The first protection plate 102 features an output receptacle 116 through which the output female connector 106 is fed and a low voltage receptacle 118 through which the low voltage female connector 108 is fed. The second protection plate 104 features an input receptacle 120 through which the input female connector 110 is fed. As will be shown and described herein, the first protection plate 102 and the second protection plate 104 are particularly designed to ensure safe maintenance of the HV PDU 100.

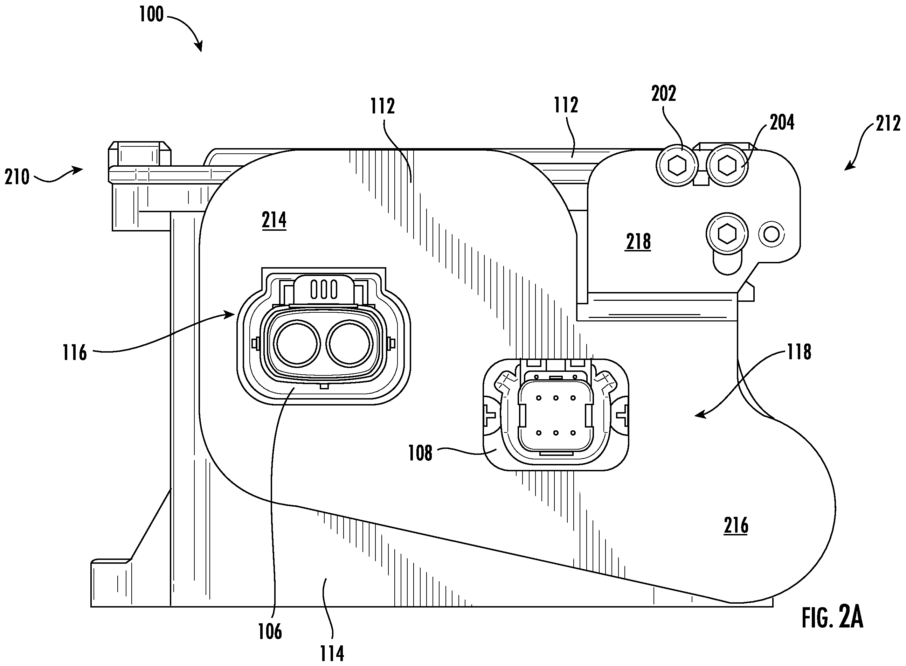

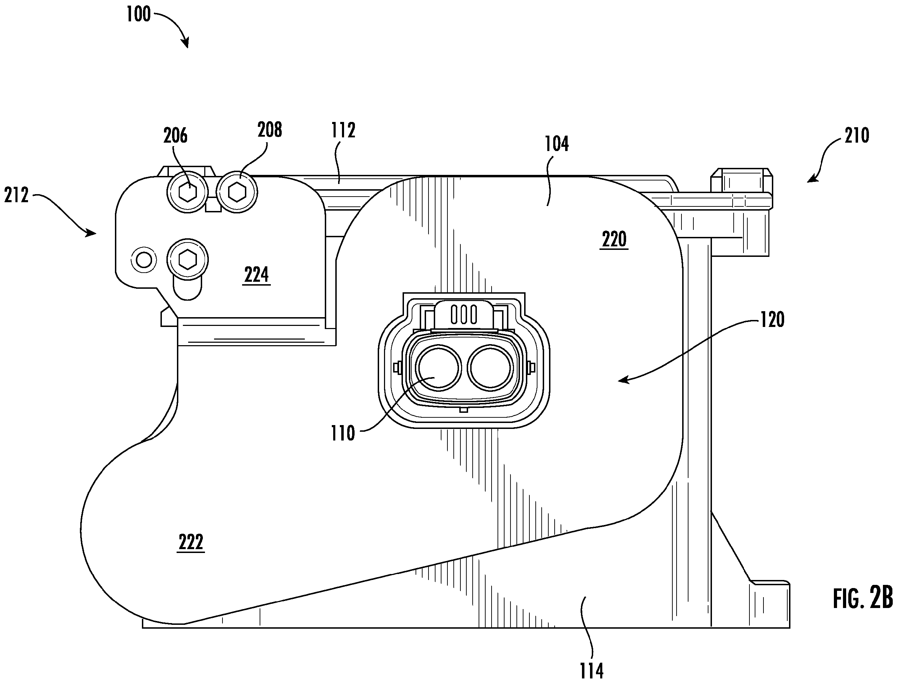

**FIGs. 2A-2B** are representative views of the HV PDU 100 of **FIGs. 1A-1C****,** according to exemplary embodiments. **FIG. 2A** is a side view featuring the first protection plate 102 and **FIG. 2B** is a side view featuring the second protection plate 104. The first protection plate 102 is adjacent and parallel to a first side of the housing 114 while the second protection plate 104 is adjacent and parallel to a second, opposite side of the housing. The housing 114 is thus sandwiched between the two protection plates 102 and 104.

As shown in **FIG. 2A****,** the first protection plate 102 includes the output receptacle 116, which surrounds the output female connector 106, and the low voltage receptacle 118, which surrounds the low voltage female connector 108. Structurally, the first protection plate 102 has a front portion 214, a back portion 216, and a connector portion 218. The output receptacle 116 is located in the front portion 214 while the low voltage receptacle 118 is disposed between the front portion 214 and the back portion 216.

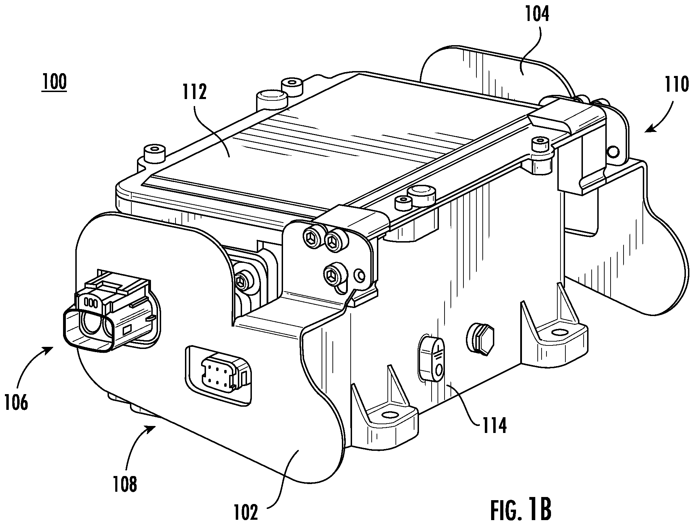

In some embodiments, the connector portion 218 is in a different plane than the front portion 214 and the back portion 216, whereas the front portion 214 and the back portion 216 are in the same plane (see **FIG. 1B**). In some embodiments, the front portion 214, the back portion 216, and the connector portion 218 are formed from a unitary material, such as metal, with the connector portion 218 being parallel to the front 214 and back 216 portions.

In exemplary embodiments, the first protection plate 102 also includes a screw 202 and a screw 204, located in the connector portion 218, for securing the first protection plate 102 to the HV PDU 100. In exemplary embodiments, the screws 202 and 204 engage with the cover 112 of the HV PDU 100.

The cover 112 has a front 210 and a back 212. In the illustration of FIG. 2A, the front 210 is on the left side and the back 212 is on the right side. When removed from the housing 114, the front 210 of the cover 112 is lifted upward and disengages from the housing 114 while the back 212 of the cover 112 remains connected to the housing 114, such as with a hinge. In exemplary embodiments, the first protection plate 102, which remains parallel to the side of the housing 114, rotates in an upward direction when the cover 112 is opened away from the housing 114. When this occurs, the front portion 214 of the first protection plate 102 is disposed above the housing 114 while the back portion 216 is blocking one or more of the output receptacle 116 and the low voltage receptacle 118.

As shown in **FIG. 2B**, the second protection plate 104 includes the input receptacle 120, which surrounds the input female connector 110. Structurally, the second protection plate 104 has a front portion 220, a back portion 222, and a connector portion 224. The input receptacle 120 is located in the front portion 220.

In some embodiments, the connector portion 224 is in a different plane than the front portion 220 and the back portion 222, where the front portion 220 and the back portion 224 are in the same plane (see **FIG. 1A**). In some embodiments, the front portion 220, the back portion 222, and the connector portion 224 are formed from a unitary material, with the connector portion 224 being parallel to the front 220 and back 222 portions.

In exemplary embodiments, the second protection plate 104 also includes a screw 206 and a screw 208, located in the connector portion 224, for securing the second protection plate 104 to the HV PDU 100. In exemplary embodiments, the screws 206 and 208 engage with the cover 112 of the HV PDU 100.

In the illustration of **FIG. 2B**, the front 210 of the cover 112 on the right side and the back 212 of the cover 112 is on the left side. When the cover 112 is removed from the housing 114, the front 210 is lifted upward and disengages from the housing 114 while the back 212 remains connected to the housing, such as with a hinge. In exemplary embodiments, the second protection plate 104, which remains parallel to the side of the housing 114, rotates in an upward direction when the cover 112 is opened away from the housing 114. When this occurs, the front portion 220 of the second protection plate 104 is disposed above the housing 114 while the back portion 222 is blocking the input receptacle 120.

Thus, in exemplary embodiments, it is not possible to rotate the first protection plate 102 until both the output female connector 106 and the low voltage female connector 108 are removed (unplugged). Because the first protection plate 102 is connected to the cover 112, it is therefore also not possible to open the cover 112 until both the output female connector 106 and the low voltage female connector 108 are removed (unplugged).

Likewise, in exemplary embodiments, it is not possible to rotate the second protection plate 104 until the input female connector 110 is removed. Because the second protection plate 104 is connected to the cover 112, it is also not possible to open the cover 112 until the input female connector 110 is removed.

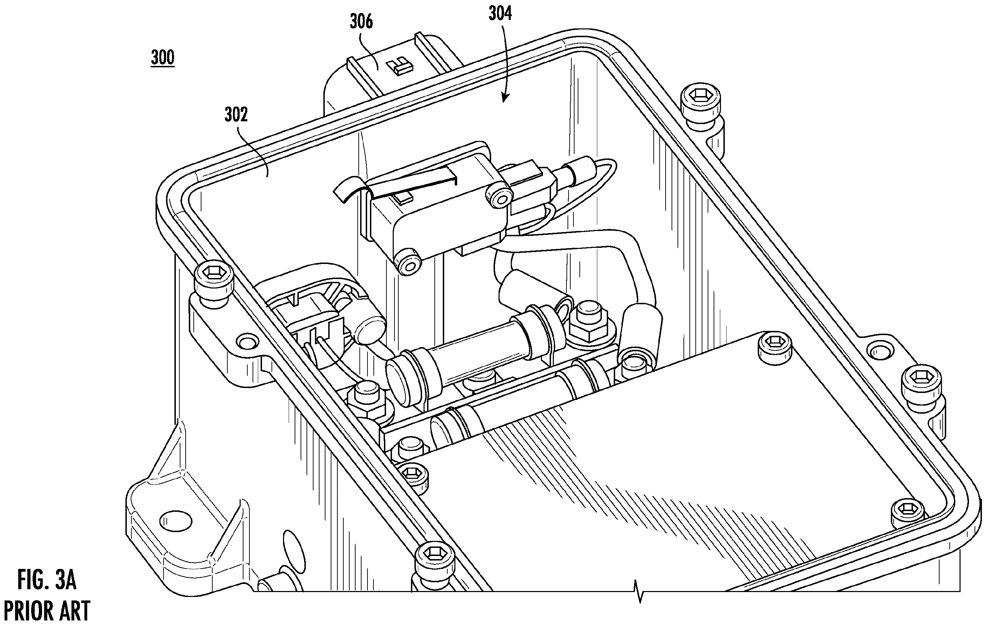

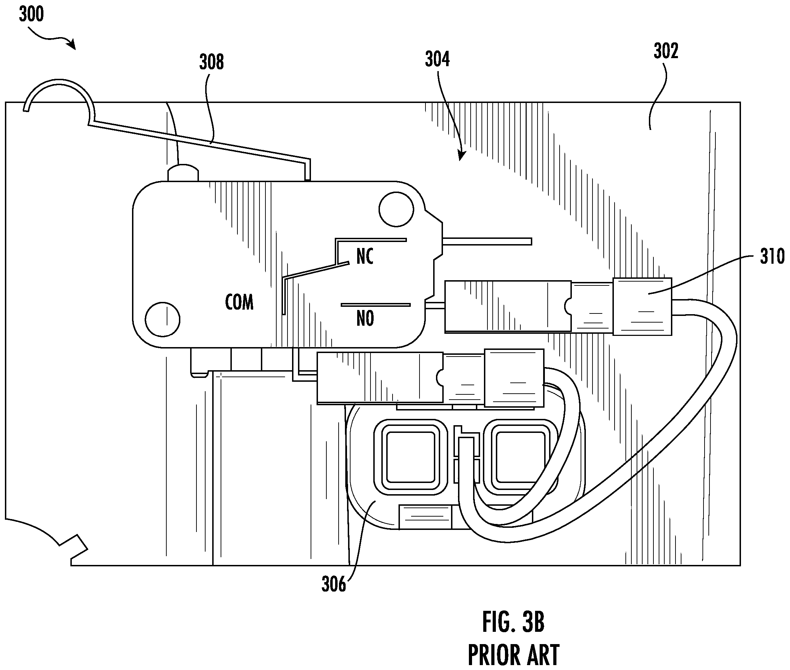

**FIGs. 3A-3B** are representative drawings of an HV PDU 300, according to the prior art. **FIG. 3A** is an overhead perspective view of the interior and **FIG. 3B** is a side interior view of the HV PDU 300. The HV PDU 300 features a lid switch 304 disposed inside a housing 302. The lid switch 304 is located on an inside wall of the housing 302, opposite a female connector 306. As shown particularly in **FIG. 3B**, the lid switch 304 features a microswitch 310 which includes a lever 308 designed to electrically disengage circuitry inside the HV PDU 300 as soon as the cover (not shown) is lifted from the housing 302. The lever 308 causes the circuitry inside the microswitch 310 to change from normally opened (NO) to normally closed (NC), and vice-versa, based on the movement of the cover. The lid switch 304 thus controls whether power is delivered to the HV PDU 300 when the cover is opened.

Unfortunatley, the lid switch 304 may be unreliable in operation. There may be a switch quality issue in which the lever 308 does not work as designed. Or, the lever 308 may set the lid switch 304 to NC or NO by mistake. During maintenance, the lid switch 304 is not easily observable until the cover of the HV PDU 300 has already been removed. The deficiencies of the lid switch 304 can result in failure of the PDU, electric shock, or worse.

The HV PDU 100 is different from the prior art HV PDU 300 in several ways. The HV PDU 100 is a special mechanical design in which the first protection plate 102, the second protection plate 104, or both the first and second protection plates, are mounted with the cover 112 to ensure a 100% power-off of the HV PDU 100 in response to opening of the cover 112. The mechanical design of the HV PDU 100 is more reliable than the lid switch 304 design of the prior art HV PDU 300. The HV PDU 100 may be implemented in multiple different ways, as described and illustrated below.

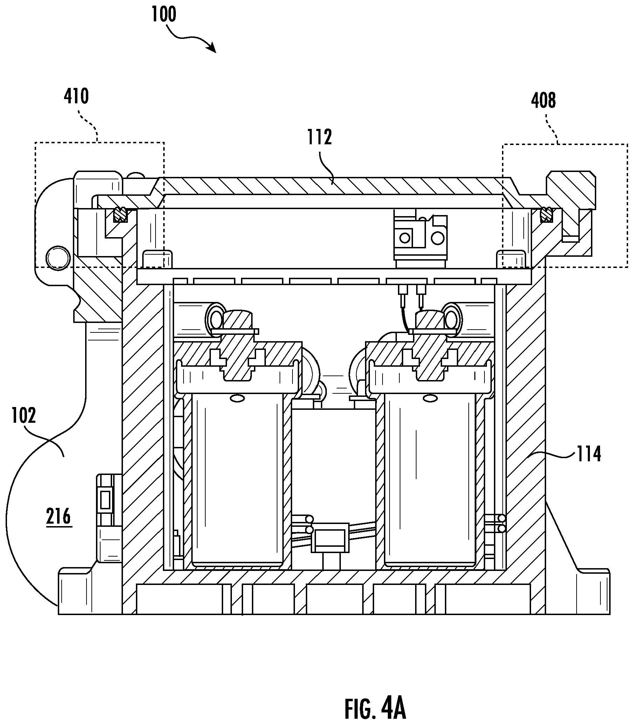

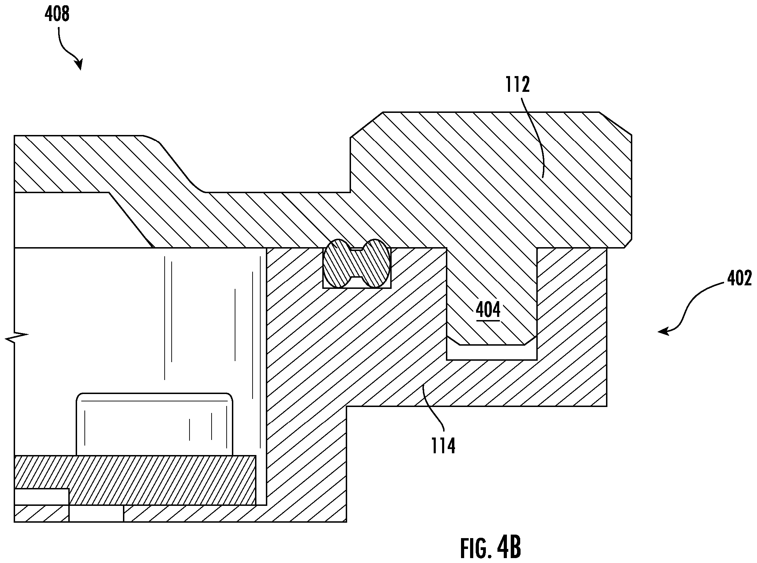

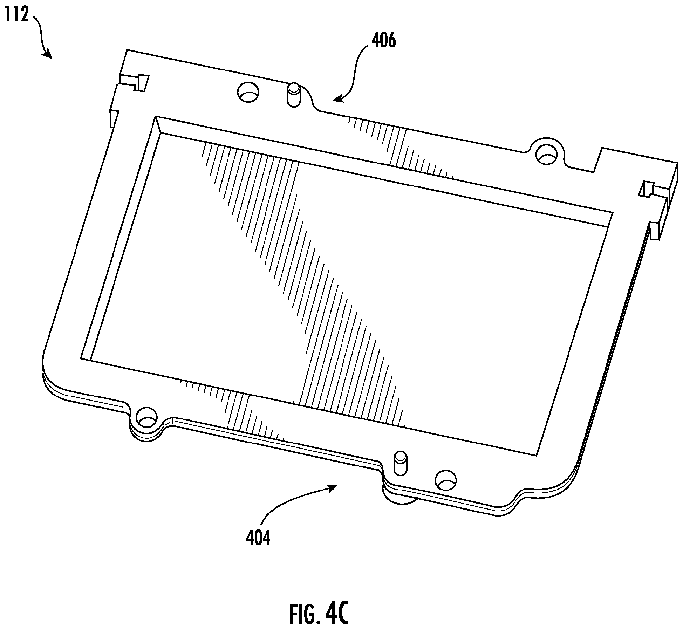

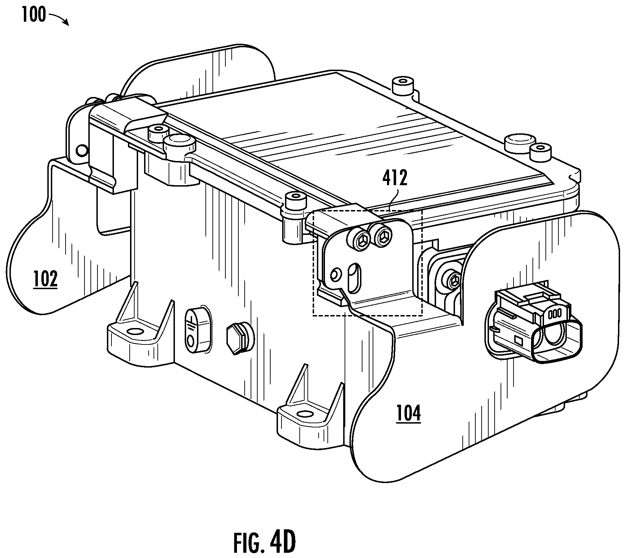

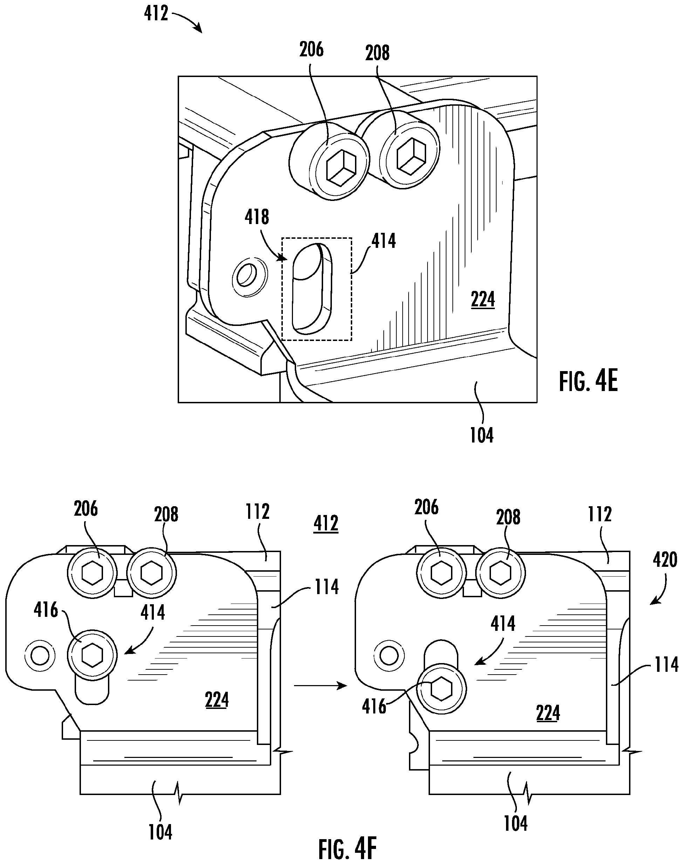

**FIGs. 4A-4F** are representative drawings of a U-slot design implemented in the HV PDU 100, according to exemplary embodiments. **FIG. 4A** is a side cross-sectional view and **FIG. 4B** is a detailed cross-sectional view of the HV PDU 100, **FIG. 4C** is a perspective view of the cover 112, **FIG. 4D** is a perspective view of the U-slot portion of the HV PDU 100, **FIG. 4E** is a detailed perspective view of the U-slot portion, and **FIG. 4F** is a detailed side view of implementation of the U-slot.

The cover 112, housing 114, and the first protection plate 102 are visible in **FIG. 4A****.** Because the view is a cross-section, the second protection plate 104 is not visible. A front join region 408 and a back join region 410 are shown, with the back join region 410 also featured in the detailed view of **FIG. 4B****.**

In exemplary embodiments, as illustrated in **FIG. 4C****,** the cover 112 features a front post 404 and a back post 406 (**FIG. 4C**). When the cover 112 is disposed upon the housing 114, the front post 404 occupies a post receptacle 402 (**FIG. 4B**) of the front join region 408 of the housing 114. Similarly, the back post 406 occupies a second post receptacle (not shown) at the back join region 410 of the housing 114 (**FIG. 4A**). In exemplary embodiments, the front post 404 and back post 406 help to properly position the cover 112 over the housing 114.

In the perspective veiw of the HV PDU 100 (**FIG. 4D**), both the first protection plate 102 and the second protection plate 104 are shown, with the housing 114 and cover 112 sandwiched therebetween. A U-slot region 412 is also shown, with a detailed view of the U-slot region 412 in **FIGs. 4E-4F****.** The U-slot region 412 is shown for the second protection plate 104, although the principles shown and described herein are also valid for the first protection plate 102.

A U-slot 414 is disposed in the connector portion 224 of the second protection plate 104. A U-slot screw 416 fits into the U-slot 414 and is able to move vertically along the axis of the U-slot 414, in a downward direction. The U-slot screw 416 is attached to a bolt (not shown) that fits into the U-slot and is received by a generally circular bolt opening 418 of the housing 114 of the HV PDU 100 (**FIG. 4E**). In exemplary embodiments, the U-slot 414 is generally shaped like a flattened oval, pill-shaped, or U-shaped, but may be different than is shown, such as rectangular-shaped, e.g., as long as the width of the U-slot 414 is wider than the diameter of the bolt connected to the U-slot screw 416 but narrower than the U-slot screw 416.

**FIG. 4F** illustrates the changes that take place in the U-slot region 412 once the cover 112 of the HV PDU 100 is opened, according to exemplary embodiments. On the left side of the arrow, the U-slot screw 416 is disposed at the top of the U-slot 414. The cover 112 is flush against the housing 114. On the right side of the arrow, the cover 112 is opened, as indicated by the opening space 420 between the cover 112 and the housing 114 and the U-slot screw 416 is disposed at the bottom of the U-slot 414. The U-slot screw 416 thus moves downward vertically within the U-slot 414. In exemplary embodiments, the vertical movement of the U-slot screw 416 does not exceed the height of the front post 404 and back post 406. Further, in exemplary embodiments, the U-slot screw 416 is the rotating axis of the second protection plate 104. Thus, the second protection plate 104 has moved upward along with the movement of the cover 112.

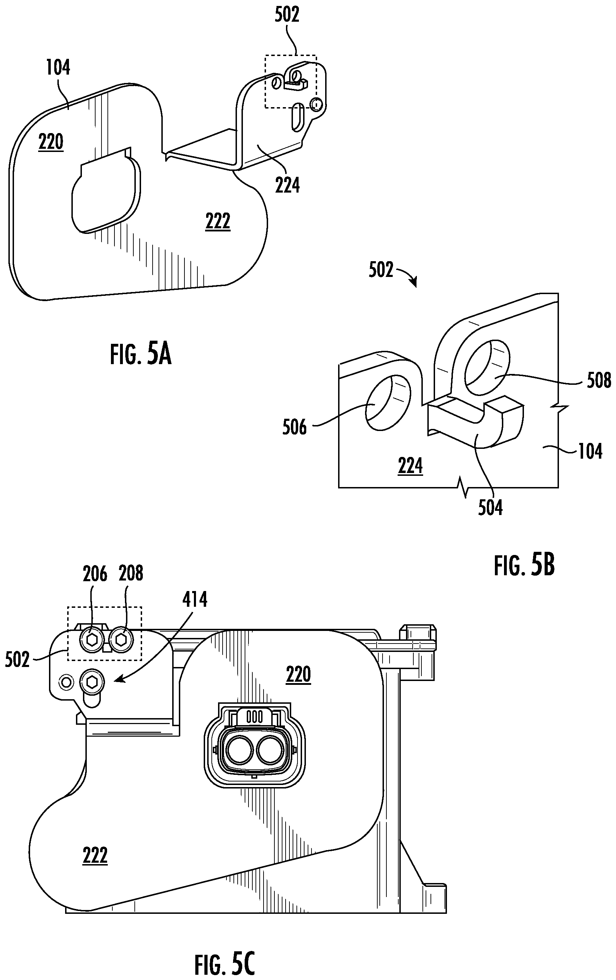

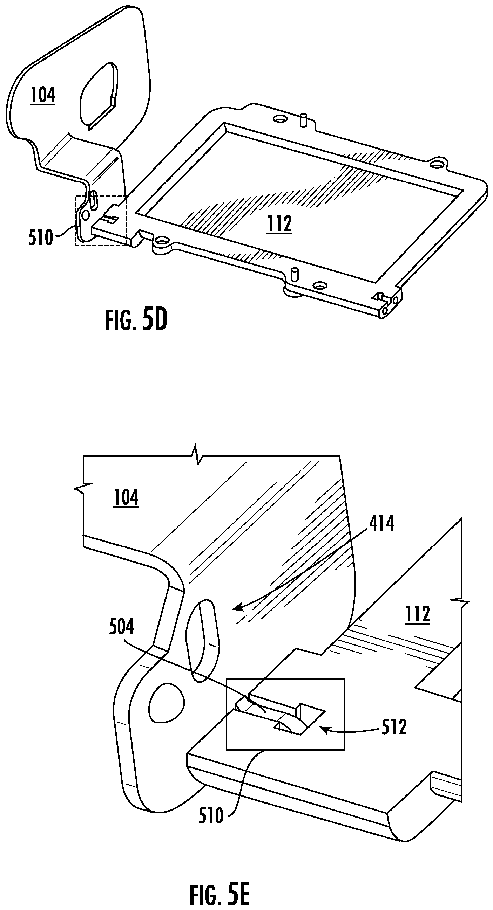

**FIGs. 5A-5E** are representative drawings of a hook design of the HV PDU 100, according to exemplary embodiments. **FIG. 5A** is a perspective view, **FIG. 5B** is a detailed perspective view, and **FIG. 5C** is a side view of the second protection plate 104 with the hook feature; **FIG. 5D** is a perspective view and **FIG. 5E** is a detailed perspective view of the second protection plate 104 mated with the cover 112 using the hook feature. The second protection plate 104 is featured in **FIGs. 5A-5E** although the principles shown and described may be applied to the first protection plate 102 as well.

An inside view of the second protection plate 104 is shown in **FIG. 5A****.** The second protection plate 104 includes the front portion 220, back portion 222, and connector portion 224 as before. In the connector portion 224, there is a hook detail 502, which is illustrated in detail in **FIG. 5B****.** Recall that the second protection plate 104 is connected to the cover 112 of the HV PDU 100 using screws 206 and 208 (**FIG. 5C**). The hook detail 502 features screw hole 506 and screw hole 508, with a hook 504 disposed therebetween. In exemplary embodiments, the hook 504 is a substantially rectangular-cube-shaped form attached to the connector portion 224 of the second protection plate 104, with a bent-up portion at the distal end, forming a hook-like appearance. In exemplary embodiments, the hook 504 is formed of the same material used for the second protection plate 104.

**FIG. 5C** shows that the hook 504 is just above the U-slot region 412 with the screws 206 and 208 being on either side of the hook 504. A fitting detail 510 in **FIGs. 5D-5E** shows that the hook 504 fits into a hook slot 512 in the cover 112 of the HV PDU 100. Notice that **FIG. 5E** shows the features upside down, with the U-slot 414, which is beneath the hook detail 502 in **FIG. 5C****,** being above the hook detail 502 in **FIG. 5E****.** Thus, in exemplary embodiments, the screws 206 and 208 and the hook 504 help to secure the cover 112 to the second protection plate 104. In exemplary embodiments, the hook 504 ensures that, even if the screws 206 and 208 are removed, the second protection plate 104 nevertheless remains attached to the cover 112, which ensures safety during maintenance of the HV PDU 100.

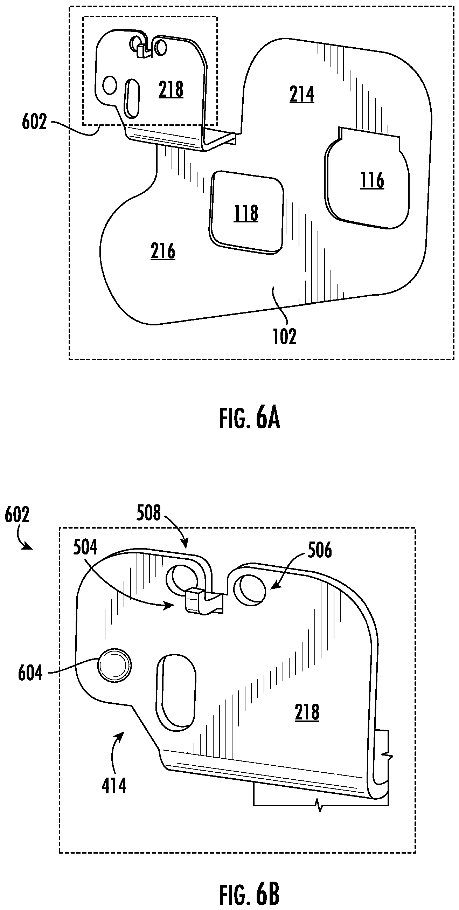

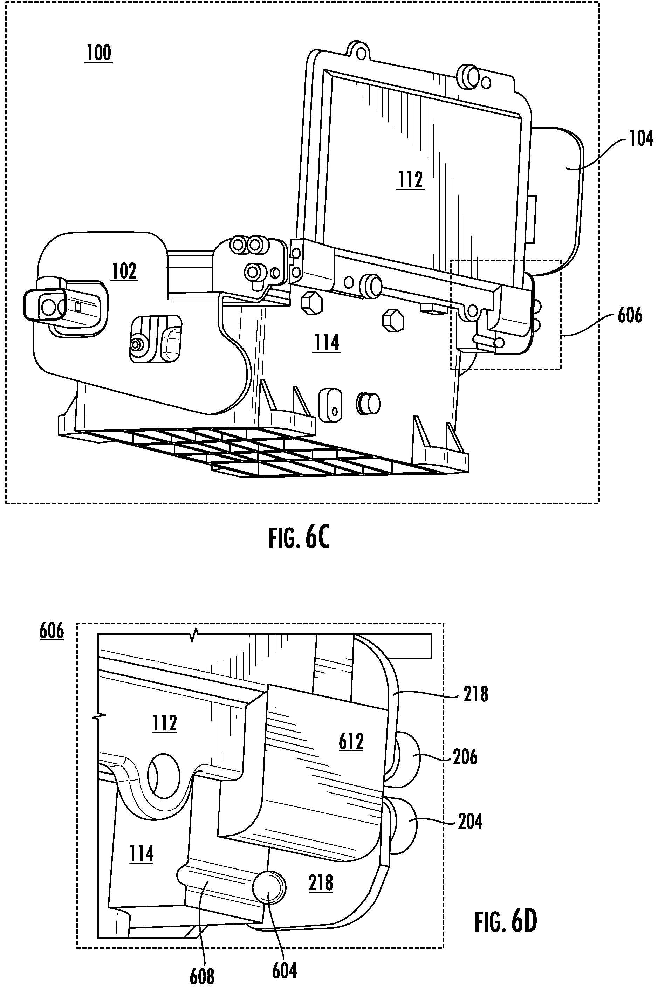

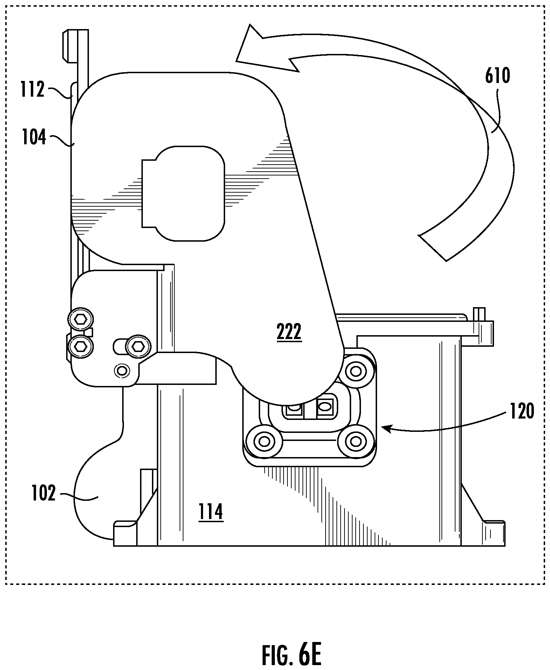

**FIGs. 6A-6E** are representative drawings of a bump ball design of the HV PDU 100, according to exemplary embodiments. **FIG. 6A** is a perspective view and **FIG. 6B** is a detailed perspective view of the bump ball design in the first protection plate 102; **FIG. 6C** is a perspective view and **FIG. 6D** is a detailed perspective view of the bump ball design in the housing 114; and **FIG. 6E** is a side view of the HV PDU 100. The bump ball design is shown with for the first protection plate 102. However, the principles of the bump ball design are also applicable to the second protection plate 104.

An inside view of the first protection plate 102 is shown in **FIG. 6A****.** The front portion 214, back portion 216, and connector portion 218 are shown as before. The output receptacle 116 (for receiving the output female connector 106) and the low voltage receptacle 118 (for receiving the low voltage female connector 108) are also shown. In exemplary embodiments, a bump ball design detail 602 is shown as part of the connector portion 218 of the first protection plate 102. The bump ball design detail 602 is shown more particularly in **FIG. 6B****.**

A bump ball 604 is shown in the connector portion 218 of the first protection plate 102. Like the hook 504, the bump ball 604 is on the inside of the connector portion 218, adjacent the side of the housing 114 where the first protection plate 102 is to be connected. The bump ball 604 is also adjacent the U-slot 414. In exemplary embodiments, the bump ball 604 is a convex protrusion on the inside of the connector portion 218. Although substantially spherical in shape, the bump ball 604 may alternatively be an elongated sphere or cylindrical in shape.

**FIG. 6C** shows a bump ball detail 606 of the HV PDU 100 while a more detailed view is in **FIG. 6D****.** In the bump ball detail 606 is a fitting trough 608 disposed along a back surface of the housing 114. In exemplary embodiments, the fitting trough 608 is orthogonal to the back surface of the connector portion 218 of the first protection plate 102. The fitting trough 608 is also just beneath a screw housing 612 of the housing 114, with the cover 112 fitting into the screw housing 612. In exemplary embodiments, when the cover 112 is opened (after the output female connector 106 and low voltage female connector 108 of the first protection plate 102 are removed), the bump ball 604 fits into the fitting trough 608 once the cover 112 reaches an opening angle 610 (**FIG. 6E**).

Thus, in exemplary embodiments, the bump ball 604 and the fitting trough 608 provide a mechanism to lock the first protection plate 102 in place once the cover 112 is opened. This helps to stabilize the cover 112 during maintenance, as components within the HV PDU 100 may be removed and other components added during the maintenance operation. The bump ball 604 and fitting trough 608 thus prevent movement of the cover 112 once the cover 112 is fully opened from the housing 114, in exemplary embodiments.

**FIG. 6E** shows the second protection plate 104 rather than the first protection plate 102, but the same principles apply. Notice that, once the cover 112 is in this position with the bump ball 604 locked into the fitting trough 608, the back portion 222 of the second protection plate 104 blocks the input receptacle 120, as designed. Similarly, once the cover 112 is fully opened, the first protection plate 102 would block the output receptacle 116 and the low voltage receptacle 118.

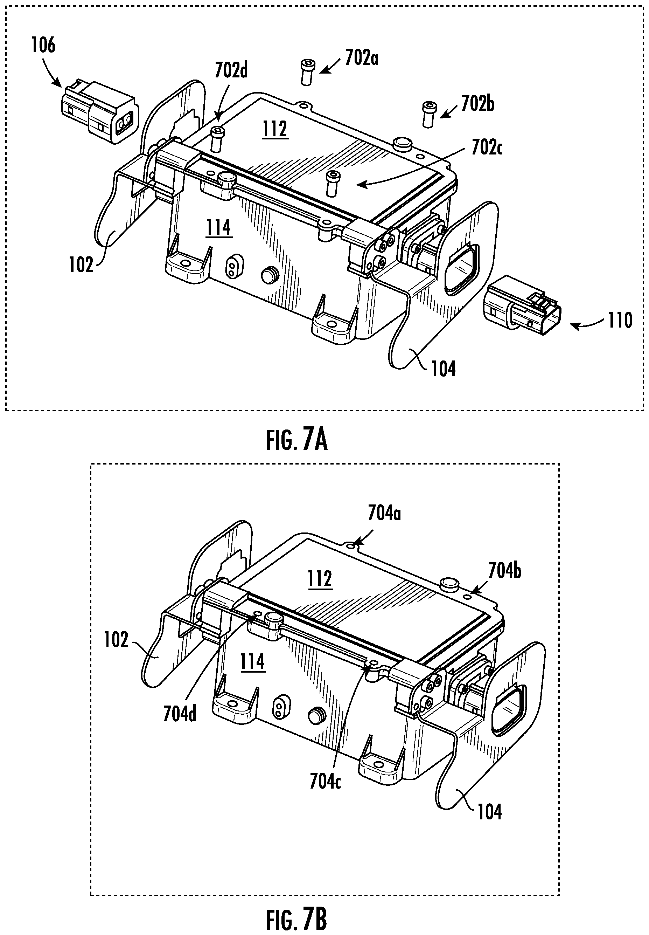

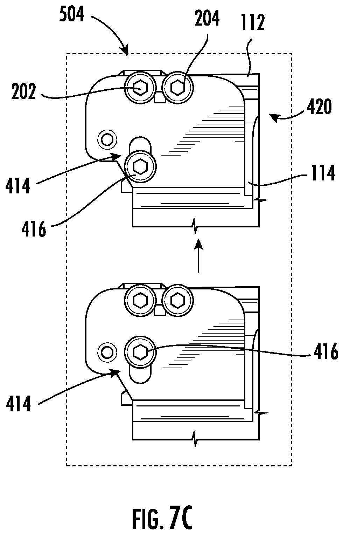

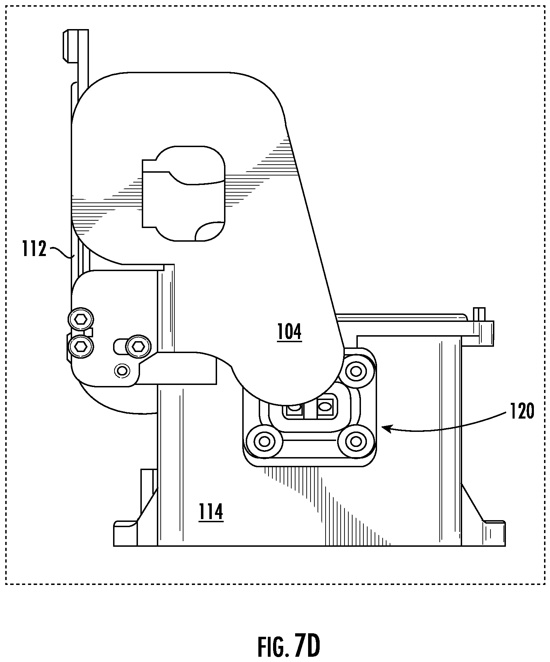

**FIGs. 7A-7D** are representative drawings of the HV PDU 100, in accordance with exemplary embodiments. **FIG. 7A** shows the HV PDU 100 as the female connectors are removed, **FIG. 7B** shows the HV PDU 100 without the female connectors, **FIG. 7C** is a detailed view of the second protection plate 104 as the U-bolt feature is engaged, and **FIG. 7D** shows the HV PDU 100 with the cover 112 rotated.

In **FIG. 7A****,** the output female connector 106 and the input female connector 110 are removed from the HV PDU 100. Although not shown, the low voltage female connector 108 is also removed. Bolts connecting the cover 112 to the housing 114 are also removed. In exemplary embodiments, the cover 112 is secured using four bolts 702a, 702b, 702c, and 702d (collectively, "bolts 702") which feed into respective bolt receptacles 704a, 704b, 704c, and 704d (collectively, "bolt receptacles 704"). The cover 112 may be secured to the housing 114 using more or fewer bolts 702. The order of removal does not matter, the bolts 702 may be removed from the bolt receptacles 704 before the output and input female connectors 106 and 110 are removed, and vice-versa. The HV PDU 100 after the bolts 702 and the connectors 106 and 110 are removed is shown in **FIG. 7B****.**

At this stage, the cover 112 can be removed from the housing 114 of the HV PDU 100. The removal of the cover 112 causes the U-slot screw 416 to move upward in the U-slot 414, as illustrated in **FIG. 7C****.** The opening space 420 shows that the cover 112 is moving away from the housing 114. The hook 504 is also securing the first protection plate 102 (or second protection plate 104) to the cover 112. In **FIG. 7D****,** the cover 112 is fully opened and the bump ball 604 is seated in the fitting trough 608, thus ensuring that the cover 112 will not shut until maintenance is complete. In this fully opened position, the second protection plate 104 is blocking the input receptacle 120 from being able to receive the input female connector 110.

As used herein, an element or step recited in the singular and proceeded with the word "a" or "an" should be understood as not excluding plural elements or steps, unless such exclusion is explicitly recited. Furthermore, references to "one embodiment" of the present disclosure are not intended to be interpreted as excluding the existence of additional embodiments that also incorporate the recited features.

While the present disclosure refers to certain embodiments, numerous modifications, alterations, and changes to the described embodiments are possible without departing from the sphere and scope of the present disclosure, as defined in the appended claim(s). Accordingly, it is intended that the present disclosure is not limited to the described embodiments, but that it has the full scope defined by the language of the following claims, and equivalents thereof.

## Claims

1. A high-voltage power distribution unit comprising:
a housing to hold an electrical device, the housing having a top opening;
a cover to be placed over the top opening, wherein the housing and the cover form a closed structure; and
a protection plate disposed on a first side of the housing, the protection plate having an output receptacle through which an output female connector fits.

2. The high-voltage power distribution unit of claim 1, wherein the cover cannot be moved away from the housing until the output female connector is unplugged from the housing.

3. The high-voltage power distribution unit of claim 1 or 2, wherein the protection plate is coupled to the cover using a screw.

4. The high-voltage power distribution unit of claim 3, wherein the protection plate further comprises a connector portion to couple the protection plate to the cover, the connector portion further comprising a U-slot to receive a second screw, wherein the second screw moves vertically downward in the U-slot as the cover is removed from the housing.

5. The high-voltage power distribution unit of claim 4, wherein the connector portion further comprises a hook disposed between the screw and a third screw, wherein the hook fits into a hook slot of the cover.

6. The high-voltage power distribution unit of claim 5, the connector portion further comprising a bump ball disposed adjacent the U-slot, wherein the bump ball fits into a fitting trough of the housing when the cover is fully opened from the housing.

7. The high-voltage power distribution unit of claim 6, wherein the bump ball is a convex protrusion disposed on an inside surface of the connector portion of the protection plate.

8. The high-voltage power distribution unit of any of the preceding claims, further comprising a second protection plate disposed on a second side of the housing, the second side being opposite the first side, the second protection plate having an input receptacle through which an input female connector fits.

9. The high-voltage power distribution unit of claim 8, wherein the cover cannot be moved away from the housing until the input female connector is unplugged from the housing.

10. The high-voltage power distribution unit of claim 8 or 9, wherein the second protection plate further comprises a connector portion to couple the second protection plate to the cover, the connector portion further comprising a U-slot to receive a screw, wherein the screw moves vertically downward in the U-slot as the cover is removed from the housing, preferably wherein the connector portion further comprises a hook disposed between a second screw and a third screw, wherein the hook fits into a hook slot of the cover, more preferably the connector portion further comprising a bump ball disposed adjacent the U-slot, wherein the bump ball fits into a fitting trough of the housing when the cover is fully opened from the housing.

11. A power distribution unit comprising:
a housing with a cover placed over a top opening of the housing, the housing and cover forming a rectangular cube structure housing an electrical device; and
a protection plate having an input receptacle through which an input female connector fits, wherein the protection plate is coupled to the cover;
wherein the cover is not removable from the housing until the input female connector is removed from the housing.

12. The power distribution unit of claim 11, further comprising a second protection plate having an output receptacle through which an output female connector fits, preferably wherein the second protection plate is coupled to the cover and the cover is not removable from the housing until the output female connector is removed from the housing.

13. The power distribution unit of claim 11 or 12, wherein the protection plate further comprises a hook disposed between a pair of screws, wherein the hook fits into a hook slot of the cover, preferably wherein the cover further comprises a bolt and the housing comprises a bolt receptacle, wherein the cover is secured to the housing by feeding the bolt into the bolt receptacle, more preferably wherein the bolt is removed from the bolt receptacle before the cover is removed from the housing.

14. The power distribution unit of any of the preceding claims 11-13, wherein the protection plate further comprises a U-slot and a screw that fits through the U-slot and is received into a screw hole of the cover, wherein the screw moves vertically in a downward direction inside the U-slot in response to the cover being removed from the housing, preferably wherein the protection plate further comprises a bump ball disposed on an inside surface of the protection plate adjacent the housing, wherein the bump ball is received into a fitting trough of the housing when the cover is fully opened, wherein the bump ball and fitting trough prevent movement of the cover.

15. Use of a high voltage distribution unit according to any of the preceding claims 1-10, or a power distribution unit according to any of the claims 11-14 for distributing high voltage power.
